# EUROPÄISCHE PATENTSCHRIFT

(11) **EP 2 764 473 B1**
(45) Veröffentlichungstag und Bekanntmachung des Hinweises auf die Patenterteilung: **12.12.2018**
(21) Anmeldenummer: 12778607.7
(22) Anmeldetag: 27.09.2012
(51) Int. Cl.: G06K 19/077, H01R 12/59, B23K 20/00

(54) **VERFAHREN ZUR HERSTELLUNG EINER CHIPKARTE**
METHOD FOR MANUFACTURING A CHIP CARD
PROCÉDÉ POUR LA PRODUCTION D'UNE CARTE A PUCE

(30) Priorität: 04.10.2011 DE 102011114635
(43) Veröffentlichungstag der Anmeldung: 13.08.2014
(60) Teilanmeldung: 18196922.1
(73) Patentinhaber: Linxens Holding S.A.S., 78200 Mantes-la-Jolie (FR)
(72) Erfinder: MICHALK, Manfred, 99092 Erfurt (DE)
(74) Vertreter: advotec.
(86) Internationale Anmeldenummer: PCT/EP2012/004045
(87) Internationale Veröffentlichungsnummer: WO 2013/050117

(56) Entgegenhaltungen:
- WO-A2-2008/129526
- DE-A1- 10 201 112
- DE-A1- 19 500 925
- DE-A1- 19 521 111
- DE-A1- 19 710 144
- DE-A1-102007 037 167
- US-A1- 2009 057 843

## Beschreibung

Die Erfindung betrifft eine Chipkarte umfassend einen in seiner Oberseite mit einer Kavität versehenen Kartenkörper und ein in der Kavität angeordnetes Chipmodul, wobei das Chipmodul derart in die Kavität eingesetzt ist, dass Modulkontakte des Chipmoduls Antennenkontakten einer im Kartenkörper angeordneten Antenne zugewandt sind, die in einem Boden der Kavität angeordnet sind, und die elektrische Kontaktierung der Modulkontakte und der Antennenkontakte über in der Kavität angeordnete, aus Kontaktleitern gebildete Drahtverbindungen erfolgt. Des Weiteren betrifft die vorliegende Patentanmeldung ein Verfahren zur Herstellung einer derartigen Chipkarte.
Aus der WO 2008/129526 ist eine Chipkarte der eingangs genannten Art bekannt, bei der Antennenkontakte einer im Kartenkörper angeordneten Antenne, die im Boden einer Kavität des Kartenkörpers angeordnet sind, mit Modulkontakten eines Chipmoduls kontaktiert sind, das in die Kavität eingesetzt ist. Zur Herstellung der elektrisch leitfähigen Verbindung zwischen dem Chipmodul und der im Kartenkörper angeordneten Antenne werden zunächst vergrößerte Antennenkontakte dadurch ausgebildet, dass die Enden der die Antenne ausbildenden Windungen mit Metallblättchen versehen werden. Anschließend erfolgt eine Kontaktierung von Anschlussleitern, die als dünne Drähte ausgebildet sind, mit den durch die Metallblättchen ausgebildeten Antennenkontakten. Zur nachfolgenden Kontaktierung der freien Enden der durch die dünnen Drähte ausgebildeten Anschlussleiter werden diese im Wesentlichen senkrecht zur Oberseite des Kartenkörpers ausgerichtet und nachfolgend mit den Modulkontakten des Chipmoduls kontaktiert. Infolge des Einsetzens bzw. Einfügens des Chipmoduls in die Kavität ergibt sich eine Anordnung, bei der die Modulkontakte und die Antennenkontakte einander zugewandt angeordnet sind und die durch die dünnen Drähte ausgebildeten Anschlussleiter sich infolge des Einsetzens des Moduls in die Kavität in einer zufälligen gestauchten Anordnung innerhalb der Kavität befinden.

Aus der DE 10201112A1 ist ein Verfahren zum Bilden einer IC-Karte sowie eine dementsprechend gebildete IC-Karte bekannt. Gemäß der Lehre dieser Druckschrift wird in einem Kartenrohling eine Ausnehmung zur Aufnahme eines Chipmoduls gebildet, es werden zwei Drahtenden der in den Kartenrohling eingebetteten Antennenspule herausgezogen, und diese Drahtenden werden mit entsprechenden Kontaktbereichen des Chipmoduls verbunden. Abschließend wird das Chipmodul in die Ausnehmung des Kartenrohlings eingesenkt und dort befestigt.

Die Herstellung dieser bekannten Chipkarten gestaltet sich entsprechend aufwendig, da eine unmittelbare Kontaktierung der als dünne Drähte ausgebildeten Anschlussleiter mit den Enden der die Antenne ausbildenden Antennenwindungen nicht möglich ist und vielmehr zuvor ein Metallblättchen zur Ausbildung einer ausreichenden Kontaktfläche zwischen dem Anschlussleiter und der Antenne in der Kavität angeordnet werden muss. Darüber hinaus erweist sich in der Praxis die Kontaktierung der freien Enden der Anschlussleiter mit den Modulkontakten des Chipmoduls als komplexer Vorgang, da zunächst ein Ausrichten der Anschlussleiter in eine gegenüber dem Kartenkörper senkrechte Erstreckung erfolgen muss und anschließend eine Handhabung der freien Enden der Anschlussleiter erfolgen muss, um diese in eine Überdeckung mit den Modulkontakten zu positionieren als Voraussetzung für einen nachfolgenden Kontaktierungsvorgang.
Die DE 19500925A1 beschreibt eine Chipkarte zur kontaktlosen Datenübertragung mit einem in einen Kartenkörper eingebauten Übertragungsmodul mit zugehöriger Antenne sowie mit einem in die Chipkarte eingebetteten Chipmodul. Hierbei werden zur elektrischen Ankopplung zwischen Antenne/Übertragungsmodul und Chipmodul diverse Kontaktierungsmöglichkeiten vorgeschlagen, darunter Löten, leitfähiges Kleben, federnde Kontakte und elastisch deformierbare Körper mit leitfähiger Oberflächenbeschichtung. Auch hier besteht die Problematik der aufwendigen und schwierig reproduzierbaren elektrischen Ankopplung zwischen Kartenkörper/Antenne und Chipmodul.

Die US 2009 0057843 erwähnt allgemein die Idee, Bonddrähte mit beliebigen Eigenschaften und insbesondere mit rechteckigem Querschnitt bei der Herstellung von Halbleiterschaltungen zu verwenden.

Ausgehend vom oben genannten Stand der Technik liegt der vorliegenden Erfindung die Aufgabe zugrunde, eine Chipkarte bzw. ein Verfahren zur

Herstellung einer Chipkarte vorzuschlagen, die bzw. das eine vereinfachte Herstellung der Chipkarten ermöglicht.

Die Erfindung wird in Anspruch 1 definiert. Die abhängigen Ansprüche enthalten bevorzugte Ausführungsbeispiele.

Die Drahtverbindungen weisen einen Kontaktleiterquerschnitt auf, dessen Breite längs einer parallel zu einer Kontaktoberfläche der Antennenkontakte bzw. der Modulkontakte angeordneten Querachse größer ausgebildet ist, als dessen Höhe längs einer senkrecht zu der Kontaktoberfläche der Antennenkontakte bzw. der Modulkontakte angeordneten Hochachse.
Mittels der solchermaßen ausgebildeten Kontaktleiter wird die Ausbildung von Drahtverbindungen möglich, die im Vergleich zu einem dünnen Drahtleiter, der einen Rundquerschnitt aufweist, eine Kontaktoberfläche aufweisen, die eine sichere Kontaktierung mit Antennenkontakten ermöglicht, ohne dass diese zuvor mit vergrößerten Anschlussflächen versehen werden müssten. Darüber hinaus weisen derartige Kontaktleiter eine vergleichsweise größere Richtungsstabilität in ihrer Längserstreckung auf. Hierdurch ist es möglich, die Kontaktleiter über eine Anschlussfläche zu positionieren, also über den Modulkontakten des Chipmoduls oder den Antennenkontakten, ohne dass hierzu das freie Ende des Kontaktleiters selbst ergriffen werden müsste. Vielmehr ist durch die gegebene Richtungsstabilität des Kontaktleiters eine definierte Ausrichtung des Kontaktleiters möglich, ohne das freie Ende des Kontaktleiters zu fixieren oder zu ergreifen.
Eine besonders sichere Kontaktierung des Anschlussleiters mit den Modulkontakten oder den Antennenkontakten ergibt sich, wenn der Kontaktleiterquerschnitt als Flachbandquerschnitt einen Unterrand und eine Oberrand aufweist, die im Wesentlichen parallel zur Querachse ausgebildet sind.

Besonders vorteilhaft hinsichtlich einer raumsparenden Unterbringung der Kontaktleiter in der Kavität, als auch hinsichtlich einer besonders sicheren Kontaktierung mit den Modulkontakten oder den Antennenkontakten ist, wenn die Kontaktleiter einen Querschnitt aufweisen, dessen Breite zumindest das 10-fache von dessen Höhe beträgt. Vorzugsweise ist der Anschlussleiter als Folienstreifen ausgebildet.

Wenn die Kontaktleiter zumindest eine Knickstelle aufweisen, kann eine geordnete raumsparende Anordnung der Drahtverbindungen in der Kavität, beispielsweise durch eine leporellartige Faltung der Kontaktleiter, erzielt werden.

Wenn die Kontaktleiter zur Ausbildung von Sollknickstellen einen Knickquerschnitt mit reduzierter Querschnittsfläche aufweisen, können die Sollknickstellen bereits durch eine entsprechende Unterteilung der Kontaktleiter vor Herstellung der Drahtverbindung vorgegeben werden. Vorzugsweise wird der Knickquerschnitt dadurch ausgebildet, dass dieser eine reduzierte Querschnittshöhe aufweist.

Die Ausbildung einer sicheren und möglichst großflächigen Kontaktierung zwischen der im Kartenkörper angeordneten Antenne und den Kontaktleitern lässt sich weiter dadurch fördern, wenn insbesondere im Fall einer durch einen Drahtleiter ausgebildeten Antenne die Kontaktfläche der Antennenkontakte aus einem mäanderförmig angeordneten Antennenleiterende des die Antenne ausbildenden Antennenleiters gebildet ist. Vorzugsweise sind dabei die Kontaktoberfläche ausbildende Oberflächenbereiche des Antennenleiters mit einer Kontaktabflachung versehen, um die Kontaktfläche zwischen der Antenne und dem Kontaktleiter noch weiter zu vergrößern.

Abweichend von einer Ausgestaltung der Antenne aus einem Drahtleiter sind jedoch auch alle anderen Antennenausgestaltungen, also insbesondere auch geätzte oder gedruckte Antennen, möglich, deren Antennenkontakte mit einer Drahtverbindung kontaktierbar sind.

Wenn das mäanderförmig angeordnete Antennenleiterende durch Antennenleiterzwischenräume voneinander beabstandete Antennenleiterabschnitte aufweist, die den Boden der Kavität überragen, wird die Kontaktfläche zwischen dem Antennenleiter und dem Kontaktleiter bzw. eine zwischen dem Kontaktleiter und dem Antennenleiter im Bereich des mäanderförmig angeordneten Antennenleiterendes ausgebildete Benetzungsfläche noch weiter vergrößert.
Die vorstehend beschriebene, vorteilhafte Ausgestaltung von mäanderförmig angeordneten Antennenenden mit Antennenleiterabschnitten, die durch Antennenleiterzwischenräume voneinander getrennt sind, wobei die Antennenleiterabschnitte den Boden einer Kavität vorzugsweise überragen, ist - auch unabhängig von der Art und Weise wie eine nachfolgende Kontaktierung mit einem Chipmodul erfolgt - bei einer Chipkarte bzw. einem zur Komplettierung mit einem Chipmodul vorgesehen Antennenmodul einer Chipkarte besonders vorteilhaft, da durch die Gestaltung der mäanderförmig angeordneten Antennenleiterenden, die vorzugsweise mit Abflachungen der Antennenleiterenden zur Ausbildung einer vergrößerten Kontaktoberfläche versehen sind, eine besonders leitfähige elektrische Kontaktierung und zugleich haltbare elektrische Kontaktierung mit dem Chipmodul ermöglicht wird.
Dabei sorgt insbesondere die den Boden der Kavität überragende Anordnung der Antennenleiterabschnitte für eine Eingriffsverbindung eines aus Lotmaterial oder auch aus einem elektrisch leitfähigem Kleber gebildeten Verbindungsmaterials mit den Antennenleiterenden.
Weiterhin ergeben sich insbesondere bei einer im Bereich der Antennenleiterenden in einem Substrat des Antennenmoduls durch Fräsbearbeitung hergestellten Kavität oxydfreie Oberflächen der Antennenleiterenden, die die Ausbildung eines unerwünschten Kontaktwiderstands zwischen den Antennenleiterenden und den Anschlussflächen eines nachfolgend kontaktierten Chipmoduls weitestgehend ausschließen.

Erfindungsgemäß erfolgt zur Herstellung der Chipkarte eine Positionierung des Chipmoduls mit nach oben gerichteten Modulkontakten. Ebenfalls erfolgt eine Positionierung des Kartenkörpers mit nach oben gerichteten Antennenkontakten. Vor der Kontaktierung der Kontaktleiter mit den Modulkontakten erfolgt eine Positionierung der Kontaktleiter relativ zu den Modulkontakten, derart, dass die Kontaktleiter im Abstand der Modulkontakte parallel zueinander ausgerichtet sind, sich in einer Überdeckungslage mit den Modulkontakten erstrecken und sich mit Kontaktleiterenden über eine Seitenkante des Chipmoduls hinaus erstrecken.

Zur Kontaktierung der Kontaktleiterenden mit den Antennenkontakten erfolgt eine Positionierung der Kontaktleiterenden in Überdeckung mit den Antennenkontakten, wobei das Chipmodul parallel zur Oberseite des Kartenkörpers und mit der Seitenkante des Chipmoduls parallel und benachbart einem Öffnungsrand der Kavität angeordnet ist.

Nachfolgend der Kontaktierung der Kontaktleiterenden erfolgt ein Abtrennen der Kontaktleiterenden zur Ausbildung der Drahtverbindungen und ein Verschwenken des Chipmoduls um seine Seitenkante und Einsetzen des Chipmoduls in die Kavität des Kartenkörpers, derart, dass die Modulkontakte den Antennenkontakten zugewandt sind.

Vorzugsweise wird dem Verschwenken eine Translationsbewegung des Chipmoduls überlagert.

Aufgrund der Verwendung eines nach Art eines Flachbands ausgebildeten Kontaktleiters ist eine zur Positionierung des Kontaktleiters über den Modulkontakten bzw. den Antennenkontakten geeignete Ausrichtung bzw. Längserstreckung des Kontaktleiters leicht möglich. Insbesondere ist es daher möglich, die Positionierung des Chipmoduls und die Positionierung des Kartenkörpers so vorzunehmen, dass die jeweils zur Kontaktierung einander zugeordneten Kontakte, also jeweils ein Antennenkontakt und ein Modulkontakt, fluchtend zueinander angeordnet sind, so dass bei einer entsprechend geradlinigen Erstreckung des Kontaktleiters eine für die nachfolgende Kontaktierung geeignete Relativpositionierung des Kontaktleiters zu den Antennenkontakten bzw. den Modulkontakten leicht möglich ist.

Aufgrund seiner richtungsstabilen Ausgestaltung kann der Kontaktleiter gleichzeitig sowohl zu dem Modulkontakt als auch zu dem Antennenkontakt ausgerichtet und nachfolgend kontaktiert werden. Nach erfolgter Kontaktierung kann durch ein Verschwenken des Chipmoduls um seine dem Seitenrand der Kavität benachbart angeordnete Seitenkante das Chipmodul in die Kavität überführt werden. Dabei können die mit den Modulkontakten und Antennenkontakten kontaktierten Kontaktleiter als eine Art Scharnierband die Führung dieser Schwenkbewegung unterstützen.

Besonders vorteilhaft ist es, wenn vor der Positionierung der Kontaktleiterenden über den Antennenkontakten und der Positionierung der Kontaktleiter über den Modulkontakten eine Relativpositionierung des Chipmoduls zum Kartenkörper erfolgt, derart, dass der Kartenkörper und das Chipmodul in zwei versetzt zueinander angeordneten, parallelen Ebenen angeordnet werden, und das Chipmodul oberhalb des Kartenkörpers angeordnet ist. Auf dieser Art und Weise kann die Positionierung der Kontaktleiter über den jeweiligen Anschlussflächen und die Kontaktierung der Kontaktleiter mit den Anschlussflächen, also den Antennenkontakten und den Modulkontakten, in einer Relativposition des Chipmoduls und des Kartenkörpers erfolgen, die das nachfolgende Einsetzen des Chipmoduls in die Kavität des Kartenkörpers erleichtert.

Besonders vorteilhaft ist es, wenn zur Positionierung der Kontaktleiterenden über den Antennenkontakten und des Kontaktleiters über den Modulkontakten die Kontaktleiter jeweils längs einer Zuführachse zugeführt werden, wobei die Zuführachse jeweils definiert ist durch die Verbindungslinie zwischen demjenigen Antennenkontakt und demjenigen Modulkontakt, welche durch den Kontaktleiter miteinander verbunden werden sollen. Hierdurch ist es möglich für das Chipmodul und den Kartenkörper eine Relativanordnung zu wählen, die eine kontinuierliche Zuführung der Kontaktleiter ermöglicht. Daraus ergibt sich insbesondere die Möglichkeit, die Chipkarte in einem getakteten Verfahren herzustellen, bei der jeweils die in geeigneter Relativpositionierung zueinander positionierten Komponenten, also der Kartenkörper und das Chipmodul, zur Herstellung der elektrisch leitenden Verbindung zwischen dem Kartenkörper und dem Chipmodul vor einer Kontaktleiterzuführstation positioniert werden und nach einem Vorschub der Kontaktleiter aus der Kontaktleiterzuführstation eine Kontaktierung der Kontaktleiter mit den Antennenkontakten bzw. den Modulkontakten erfolgt.

Wenn vor einer Positionierung der Kontaktleiter relativ zu den Modulkontakten und den Antennenkontakten die Kontaktleiter in einem Kontaktleiterabschnitt, der zur Ausbildung der Drahtverbindung zwischen dem Kartenkörper und dem Chipmodul dient, mit mindestens einer Sollknickstelle versehen werden, kann hierdurch eine definierte Anordnung der Drahtverbindung in der Kavität nach Einsetzen des Chipmoduls in die Kavität unterstützt werden.

Alternativ ist es auch möglich, nach Kontaktierung der Kontaktleiter mit den Modulkontakten und den Antennenkontakten und Ausbildung der Drahtverbindungen durch Abtrennung der Kontaktleiterenden die Ausbildung einer Knickstelle durch Ausknicken der Drahtverbindungen bei Ausführung der überlagerten Schwenk-/Translationsbewegung auszuführen.

Insbesondere in dem Fall, wenn zur Herstellung der Drahtverbindung zwischen dem Kartenkörper und dem Chipmodul Kontaktleiter verwendet werden, die über keinen Verbindungsmaterialauftrag, insbesondere keine Lötmaterialbeschichtung verfügen, ist es vorteilhaft, wenn vor der Positionierung der Kontaktleiter relativ zu den Modulkontakten und den Antennenkontakten auf die Modulkontakte und die Antennenkontakte blattförmig ausgebildete Lotdepots aufgebracht werden.

Insbesondere zur Fixierung der Lotdepots für den nachfolgenden Lötvorgang ist es vorteilhaft, wenn vor Applikation der Lotdepots auf die Modulkontakte und die Antennenkontakte Flussmitteldepots auf die Modulkontakte und die Antennenkontakte appliziert werden. Nachfolgend werden eine bevorzugte Variante des erfindungsgemäßen Verfahrens sowie bevorzugte Ausführungsformen der erfindungsgemäßen Chipkarte anhand der Zeichnung näher erläutert. Es zeigen:
- Fig. 1:: eine Positionierungsphase während der Herstellung einer ersten Ausführungsform einer Chipkarte mit Relativpositionierung des Chipmoduls zum Kartenkörper;
- Fig. 2:: eine Kontaktleiterzuführung der Kontaktleiter;
- Fig. 3:: eine Detaildarstellung der Positionierung eines Kontaktleiters über einem Antennenkontakt des Kartenkörpers bzw. einem Modulkontakt des Chipmoduls;
- Fig. 4:: eine Kontaktierungsphase mit Kontaktierung der Kontaktleiter zur Ausbildung von Drahtverbindungen zwischen einer Antenne des Kartenkörpers und dem Chipmodul;
- Fig. 5:: eine Einsetzphase mit Einschwenken des Chipmoduls in die Kavität des Kartenkörpers;
- Fig. 6:: eine Schnittdarstellung der Chipkarte mit in die Kavität des Kartenkörpers eingesetztem Chipmodul;
- Fig. 7:: eine Schnittdarstellung einer alternativ ausgeführten Chipkarte mit in die Kavität des Kartenkörpers eingesetztem Chipmodul;
- Fig. 8:: das gemäß der Darstellung in Fig. 7 in die Kavität eingesetzte Chipmodul während eines Einsetzvorgangs;
- Fig. 9:: eine Draufsicht auf eine in einem Kartenkörper ausgebildete Kavität;
- Fig. 10:: eine Teilschnittdarstellung der in Fig. 9 dargestellten Kavität;
- Fig. 11:: ein Chipmodul in einer ersten Phase einer überlagerten Schwenk-/Translationsbewegung;
- Fig. 12:: das Chipmodul in einer zweiten Phase einer überlagerten Schwenk-/Translationsbewegung;
- Fig. 13:: das Chipmodul in einer dritten Phase einer überlagerten Schwenk-/Translationsbewegung.

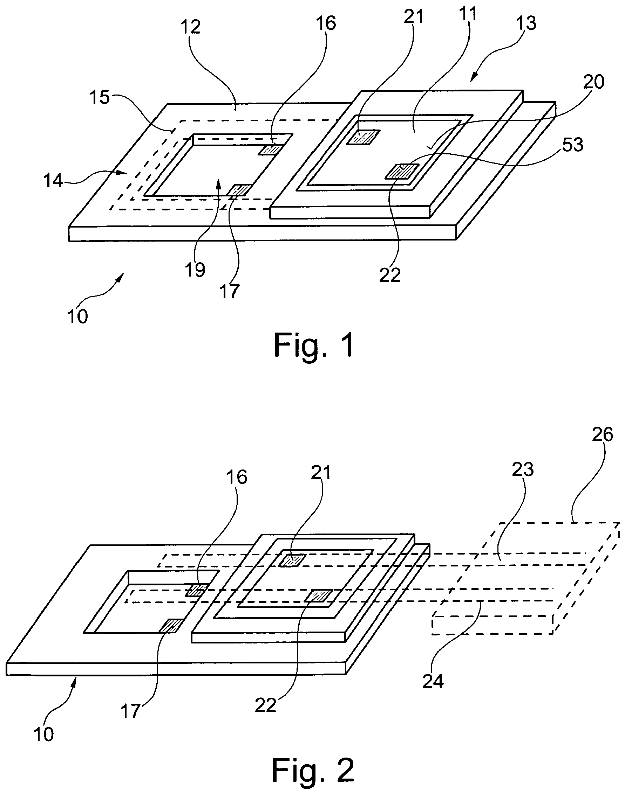

**Fig. 1** zeigt einen Kartenkörper 10 und ein Chipmodul 11, die in zwei zueinander parallelen Ebenen angeordnet sind, wobei sich das Chipmodul 11 in einer oberhalb einer Oberseite 12 des Kartenkörpers 10 angeordneten Chipmodulaufnahme 13 befindet.

Der Kartenkörper 10 weist eine im Kartenkörper 10 angeordnete Antenne 14 auf, die einen Antennenleiter 15 zur Ausbildung von Antennenwindungen aufweist, und der zur Kontaktierung mit dem Chipmodul 11 Antennenkontakte 16, 17 aufweist, die in einem Boden 18 einer im Kartenkörper 10 ausgebildeten Kavität 19 angeordnet sind.

Das in der Chipmodulaufnahme 13 angeordnete Chipmodul 11 ist an seiner in **Fig. 1** nach oben gerichteten Unterseite 20 mit Modulkontakten 21, 22 versehen, die zur Kontaktierung mit den Antennenkontakten 16, 17 dienen und die wie die Antennenkontakte 16, 17 mit ihrer Kontaktoberfläche 53 nach oben weisend angeordnet sind.

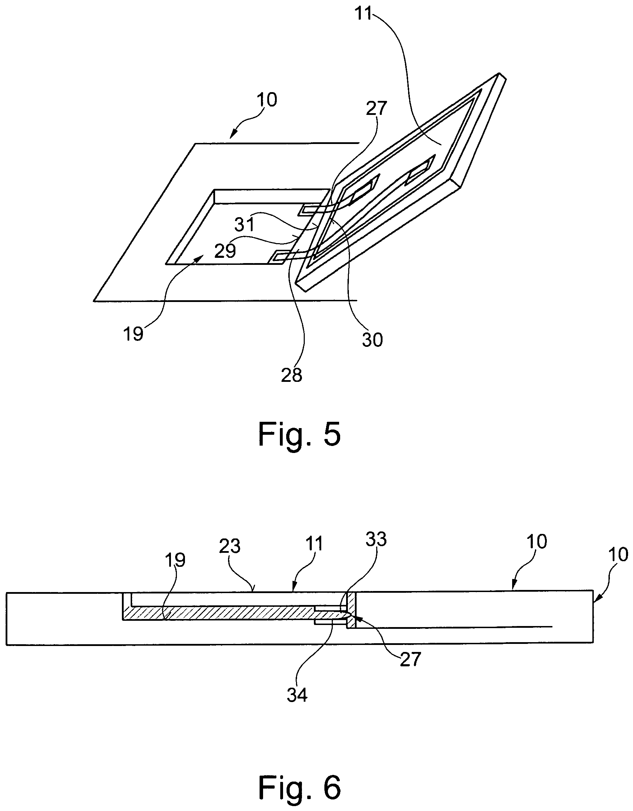

Das in **Fig. 1** dargestellte Chipmodul 11 weist auf seiner der Unterseite 20 gegenüberliegenden Oberseite 23 (**Fig. 6**) eine hier nicht näher dargestellte Kontaktanordnung auf, die einen direkten Datenzugriff auf Daten ermöglicht, die auf einem hier nicht näher dargestellten Chip des Chipmoduls 11 gespeichert sind. Die an der Unterseite 20 des Chipmoduls 11 angeordneten Modulkontakte 21, 22 ermöglichen über die Kontaktierung mit den Antennenkontakten 16, 17 der Antenne 14 die Ausbildung eines Transponders und somit alternativ oder parallel zu der Außenkontaktanordnung des Chipmoduls 11 einen berührungslosen Zugriff auf die im Chip gespeicherten Daten über eine geeignete, hier nicht näher dargestellte Leseeinrichtung. Derartige Chipkarten, die sowohl einen berührungslosen Datenzugriff als auch einen kontaktbehafteten Datenzugriff ermöglichen, werden auch als Dual-Interface-Karten (DIF) bezeichnet.

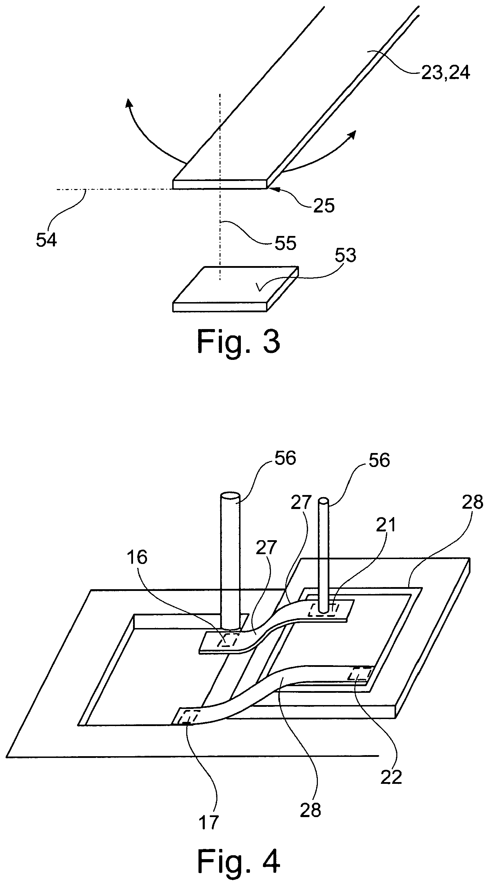

Wie **Fig. 2** zeigt, werden der aus dem Kartenkörper 10 und dem Chipmodul 11 zusammengesetzten Komponentenanordnung Kontaktleiter 23, 24 zugeführt, die einen Flachband-Querschnitt 25 aufweisen, der, wie in **Fig. 3** dargestellt, längs einer Querachse 54, die im Wesentlichen parallel zu der Kontaktoberfläche 53 des Antennenkontakts 16, 17 bzw. des Modulkontakts 21, 22 verläuft, eine Breite aufweist, die größer ist als eine Höhe des Flachband-Querschnitts 25 längs einer Hochachse 55.

Aufgrund der vorstehend beschriebenen Querschnittsausbildung weisen die in etwa flachbandartig ausgebildeten Kontaktleiter 23, 24 senkrecht zur Kontaktoberfläche 53 der Antennenkontakte 16, 17 bzw. der Modulkontakte 21, 22 eine vergrößerte Steifigkeit bzw. ein relativ großes Biegewiderstandsmoment auf, so dass die Kontaktleiter 23, 24 bzw. freie Kontaktleiterenden in einer in **Fig. 2** angedeuteten Zuführrichtung 26 im Wesentlichen geradlinig zugeführt werden können, ohne dass ein erhöhtes Risiko besteht, dass die Kontaktleiter 23, 24 seitlich ausweichen. Hierdurch ist eine zielgenaue Zuführung der Kontaktleiter 23, 24 möglich zur Erzielung einer Überdeckung mit den Antennenkontakten 16, 17 bzw. den Modulkontakten 21, 22.

Eine etwaige Verformung der Kontaktleiter 23, 24 um die Querachse 54 bzw. eine Achse parallel zur Kontaktoberfläche 53 der Antennenkontakte 16, 17 bzw. der Modulkontakte 21, 22 erweist sich für einen nachfolgenden Kontaktierungsvorgang als unerheblich, da die Kontaktierung, wie in **Fig. 4** dargestellt, vermittels eines Kontaktierungswerkzeuges 56 erfolgt, das zur Aufbringung des während der Kontaktierung erforderlichen Kontaktdrucks die Kontaktleiter 23, 24 ohnehin gegen die Kontaktoberfläche 53 der Antennenkontakte 16, 17 bzw. der Modulkontakte 21, 22 drückt. Nach erfolgter Kontaktierung bzw. nach Kontaktierung der Kontaktleiter 23, 24 mit den Modulkontakten 21, 22 mittels des Kontaktierungswerkzeuges 56 oder auch - je nach Ausführung des Kontaktierungswerkzeugs 26 - während der Kontaktierung kann ein Abtrennen von Kontaktleiterendstücken zur Ausbildung einer Drahtverbindung 27, 28 zwischen jeweils einem Antennenkontakt 16 bzw. 17 und einem Modulkontakt 21 bzw. 22 erfolgen.

**Fig. 5** zeigt, wie das Chipmodul 11 nach Herstellung der Drahtverbindungen 27, 28 zwischen den Antennenkontakten 16, 17 und den Modulkontakten 21, 22 durch ein Verschwenken um eine einem Öffnungsrand 29 der Kavität 19 benachbarte Seitenkante 30 des Chipmoduls 11 in die Kavität 19 überführt bzw. eingesetzt wird.

Bei der in **Fig. 5** dargestellten Variante des Herstellungsverfahrens, bei der das Chipmodul 11 in der Chipmodulaufnahme 13 positioniert ist, liegt eine zur Seitenkante 30 parallele Schwenkkante 31 der Chipmodulaufnahme 13 auf der Oberseite 12 des Kartenkörpers 10 bzw. auf einer hier nicht näher dargestellten, parallel zur Oberseite des Kartenkörpers 10 angeordneten Schwenkstütze auf, so dass das Verschwenken als definierte Bewegung erfolgen kann.

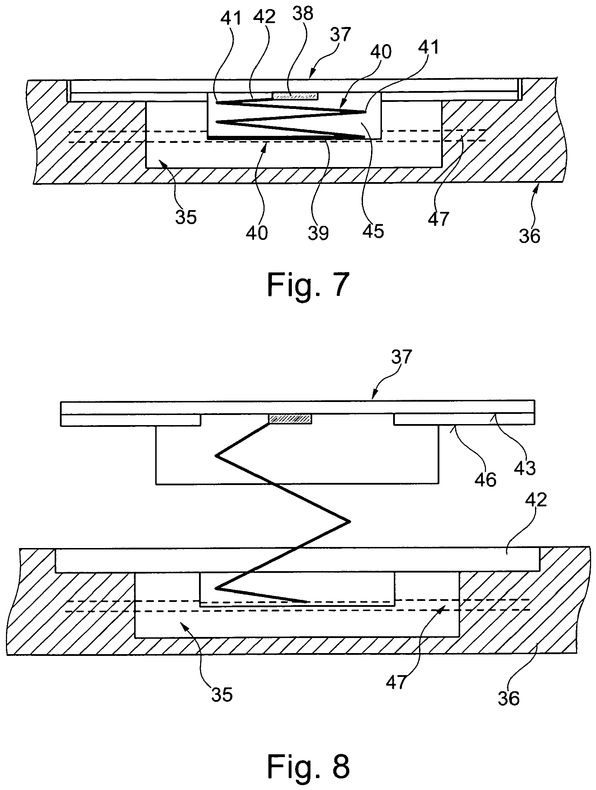

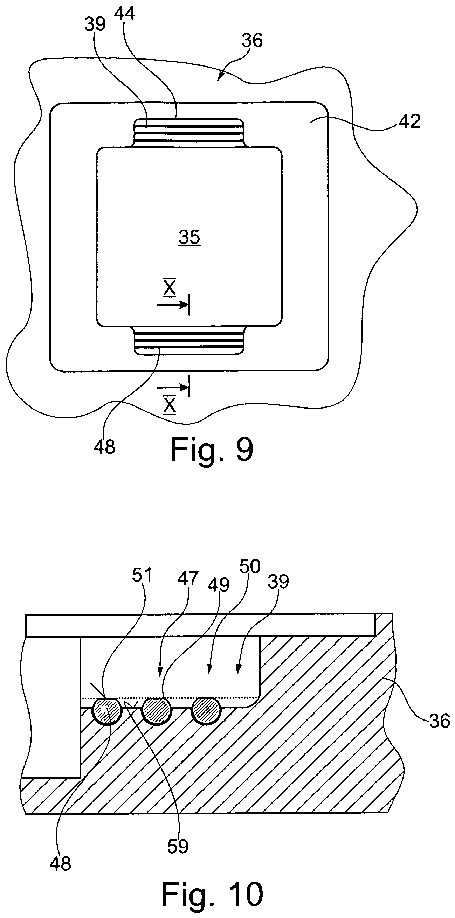

Infolge des Verschwenkens des Chipmoduls 11 bzw. des Einsetzens des Chipmoduls 11 in die Kavität 19 ergibt sich ein Abknicken bzw. eine Faltung der durch die Kontaktleiterteilstücke ausgebildeten Drahtverbindungen 27, 28, derart, dass, wie beispielsweise in der **Fig. 6** dargestellt, nach dem Einsetzen des Chipmoduls 11 in die Kavität 19 zur Ausbildung einer Chipkarte 57 durch eine Knickstelle 32 gebildete Drahtverbindungsabschnitte 33, 34 sich benachbart zueinander erstrecken bzw. aufeinander aufliegen.
Wie aus den Darstellungen in den **Fig. 7 und 8** deutlich wird, die ein in einer Kavität 35 eines Kartenkörpers 36 aufgenommenes Chipmodul 37 einer Chipkarte 58 zeigt, weist bei dieser Ausführungsform einer Chipkarte eine zwischen einem Modulkontakt 38 und einem Antennenkontakt 39 aus einem Kontaktleiterendstück ausgebildete Drahtverbindung 40 mehrere Knickstellen 41 auf, so dass die Drahtverbindung 40 im vorliegenden Fall in vier Drahtverbindungsabschnitte 42 aufgeteilt ist. Damit sich die Knickstellen 41 bei dem in **Fig. 8** schematisch dargestelltem Einsetzen des Chipmoduls 37 in die Kavität 35 an definierten Stellen ausbilden, ist der zur Herstellung der Drahtverbindung 40 verwendete Kontaktleiter 23, 24 mit hier nicht näher dargestellten Sollknickstellen versehen, die durch Querschnittsreduzierungen des Drahtquerschnitts der Kontaktleiter 23, 24 ausgebildet werden können, beispielsweise durch Einbringen von linienförmigen Einprägungen, die quer zur Längserstreckung der Kontaktleiter 23, 24 verlaufen.
Wie eine Zusammenschau der **Fig. 8** **und** **9** deutlich macht, ist die Kavität 35 des Kartenkörpers 36 abgestuft ausgebildet, mit einem umlaufenden Auflagerrahmen 42, der zur Abstützung eines Auflagerrands 43 des Chipmoduls 37 dient. Der Auflagerrahmen 42 ist im Bereich der Antennenkontakte 39 mit Einbuchtungen 44 versehen, die zur Freilegung der Antennenkontakte 39 dienen und gleichzeitig, wie aus einer Zusammenschau der **Fig.** 7 **und 8** ersichtlich, einen Aufnahmeraum oder Stauraum 45 zur Unterbringung der Drahtverbindung 40 ausbilden.

Zur Fixierung des Chipmoduls 37 im Kartenkörper 36 weist in dem dargestellten Ausführungsbeispiel der Auflagerrand 43 des Chipmoduls 37 einen Kleberauftrag 46 auf, der gleichzeitig mit dem Einsetzen des Chipmoduls 37 in die Kavität 35 eine Fixierung des Chipmoduls 37 im Kartenkörper 36 ermöglicht.

Wie die **Fig. 9 und 10** zeigen, sind die Antennenkontakte 39 einer im Kartenkörper 36 angeordneten Antenne 47 durch eine mäanderförmige Anordnung eines Antennenleiters 48 gebildet, wobei der Antennenleiter 48 zur Ausbildung einer aus einzelnen Kontaktteilflächen 49 zusammengesetzten Kontaktoberfläche 50 mit Abflachungen 51 versehen ist. Zur Ausbildung einer exponierten, aus einer Boden 52 der Kavität 35 hervorragenden Anordnung der Kontaktoberfläche 50 ist das Kunststoffmaterial des Kartenkörpers 36 in Antennenleiterzwischenräumen 53 bzw. benachbart zum Antennenleiter 48 durch eine beispielsweise durch Laserbeaufschlagung ausgeführte Ablation entfernt.

Gegebenenfalls können durch die Laserbeaufschlagung auch auf den Antennenkontakten befindliche Lackisolierschichten entfernt werden.

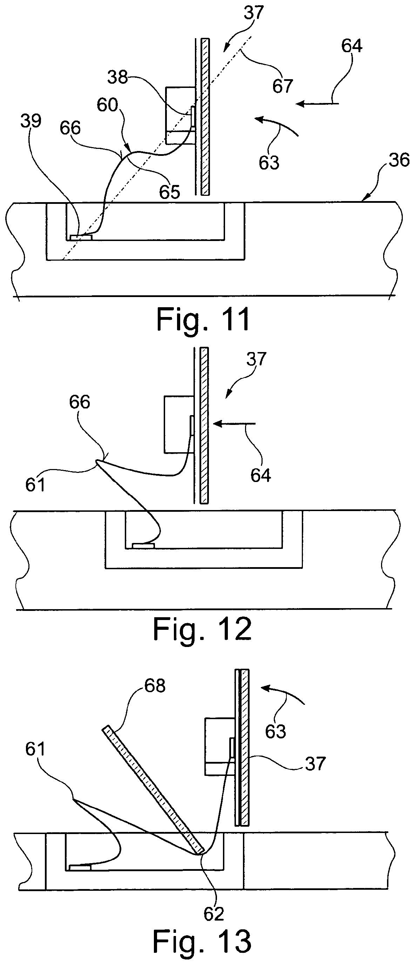

In den **Fig. 11, 12 und 13** ist am Beispiel des bereits in den **Fig. 7 und 8** dargestellten Chipmoduls 37 eine alternative Ausgestaltung einer Drahtverbindung 60 dargestellt, die sich jeweils zwischen den einander zugeordneten Antennenkontakten 39 und Modulkontakten 38 erstreckt. Im Unterschied zu der in den **Fig. 7 und 8** dargestellten Drahtverbindung 40, deren Knickstellen 41 an Sollknickstellen ausgebildet sind, die beispielsweise durch bereits in den Kontaktleitern zur Ausbildung der Drahtverbindung vorhandenen Querschnittsreduzierungen definiert sind, erfolgt die Ausbildung von Knickstellen 61 und 62 an der Drahtverbindung 60 auf die nachfolgend Bezug nehmend auf die **Fig. 11-13** erläuterte Art und Weise.

Wie **Fig. 11** zeigt, erfolgt nachfolgend der Herstellung der Drahtverbindung 60 zwischen den Modulkontakten 38 und den Antennenkontakten 39 eine Schwenkbewegung 63 des Chipmoduls 37 in die in **Fig. 11** angedeutete Richtung, wobei der Schwenkbewegung eine Translationsbewegung 64 überlagert wird oder die Schwenkbewegung mit einer Translationsbewegung kombiniert wird, die in etwa parallel zur Oberfläche des Kartenkörpers 36 erfolgt. Aufgrund dieser nachfolgend als Schwenk-/Translations-bewegung bezeichneten Vorschubbewegung des Chipmoduls 37 bildet sich in der Drahtverbindung 60 eine Drahtschleife 65 mit einem bei fortschreitender Schwenk-/Translationsbewegung enger werdendem Schleifenbogen 66 aus.

Längs einer die Modulkontakte 38 mit den Antennenkontakten 39 verbindenden Kraftachse 67 wirkt auf die Drahtverbindung 60 eine mit fortschreitender Schwenk-/Translationsbewegung zunehmende Knicklast, die in Abhängigkeit vom Drahtquerschnitt der Drahtverbindung 60 und deren Biegesteifigkeit zum Ausknicken (**Fig. 12**) der Drahtverbindung 60 an einer vorbestimmten Knickstelle 61 führt.

Wie **Fig. 13** zeigt, kann nun die Ausbildung der weiteren Knickstelle 62 unter Zuhilfenahme eines Niederhalters 68 erfolgen, der eine Umlenkstelle der Drahtverbindung 60 definiert, an der dann wieder bei Überschreiten einer Knickspannung in der Drahtverbindung 60 die Ausbildung der zweiten Knickstelle 62 erfolgt.

Nach Ausbildung der zweiten Knickstelle 62 wird dann die weitere Schwenk-/Translationsbewegung derart ausgeführt, dass am Ende der Bewegung das Chipmodul 37 in die Kavität 35 eingesetzt ist.

## Patentansprüche

1. Verfahren zur Herstellung einer Chipkarte (57, 58),
wobei die Chipkarte (57, 58) einen in seiner Oberseite (12) mit einer Kavität (19, 35) versehenen Kartenkörper (10, 36) mit einer im Kartenkörper angeordneten Antenne (14, 47) und ein in der Kavität angeordnetes Chipmodul (11, 37) umfasst,
mit folgenden Verfahrensschritten:
- Positionierung des Chipmoduls (11, 37) mit nach oben gerichteten Modulkontakten (21, 22, 38);
- Positionierung des Kartenkörpers mit nach oben gerichteten Antennenkontakten (16, 17, 39);
**gekennzeichnet durch**
- Positionierung von Kontaktleitern (23, 24) mit einem Flachbandquerschnittt (25) relativ zu den Modulkontakten, derart, dass die Kontaktleiter im Abstand der Modulkontakte parallel zueinander ausgerichtet sind, sich in einer Überdeckungslage mit den Modulkontakten erstrecken und sich mit Kontaktleiterenden über eine Seitenkante des Chipmoduls hinaus erstrecken;
- Positionierung der Kontaktleiterenden in Überdeckung mit den Antennenkontakten des Kartenkörpers, wobei das Chipmodul parallel zur Oberseite des Kartenkörpers und mit der Seitenkante (30) des Chipmoduls parallel und benachbart einem Öffnungsrand (29) der Kavität angeordnet ist;
- Kontaktierung der Kontaktleiter mit den Modulkontakten;
- Kontaktierung der Kontaktleiter mit den Antennenkontakten;
- Abtrennen der Kontaktleiterenden zur Ausbildung von Drahtverbindungen (27, 28, 40, 60) zwischen den Modulkontakten und den Antennenkontakten;
- Verschwenken des Chipmoduls um seine Seitenkante und Einsetzen des Chipmoduls in die Kavität des Kartenkörpers, derart, dass die Modulkontakte den Antennenkontakten zugewandt sind.

2. Verfahren nach Anspruch 1,
**dadurch gekennzeichnet,**
**dass** dem Verschwenken des Chipmoduls (11, 37) eine Translationsbewegung des Chipmoduls überlagert wird.

3. Verfahren nach Anspruch 2,
**dadurch gekennzeichnet,**
**dass** vor der Positionierung der Kontaktleiter (23, 24) über den Antennenkontakten (16, 17, 39) und über den Modulkontakten (21, 22, 38) eine Relativpositionierung des Chipmoduls (11, 37) zum Kartenkörper (10, 36) erfolgt, derart, dass der Kartenkörper und das Chipmodul in zwei versetzt zueinander angeordneten, parallelen Ebenen angeordnet werden und das Chipmodul oberhalb des Kartenkörpers angeordnet ist.

4. Verfahren nach Anspruch 3,
**dadurch gekennzeichnet,**
**dass** das Chipmodul (11) in einer oberhalb des Kartenkörpers (10) angeordneten Chipmodulaufnahme (13) angeordnet ist.

5. Verfahren nach Anspruch 3 oder 4,
**dadurch gekennzeichnet,**
**dass** zur Positionierung der Kontaktleiter (23, 24) über den Antennenkontakten (16, 17) und Positionierung der Kontaktleiter über den Modulkontakten (21, 22) die Kontaktleiter jeweils längs einer Zuführachse zugeführt werden, die jeweils durch denjenigen Antennenkontakt und denjenigen Modulkontakt definiert ist, welche durch den Kontaktleiter miteinander verbunden werden.

6. Verfahren nach einem der Ansprüche 1 bis 5,
**dadurch gekennzeichnet,**
**dass** vor einer Positionierung der Kontaktleiter (23, 24) relativ zu den Modulkontakten (21, 22) und Positionierung der Kontaktleiter relativ zu den Antennenkontakten (16, 17) die Kontaktleiter zumindest im Bereich eines Kontaktleiterendes, das zur Ausbildung der Drahtverbindung dient, mit zumindest einer Sollknickstelle versehen werden.

7. Verfahren nach einem der Ansprüche 1 bis 5,
**dadurch gekennzeichnet,**
**dass** nach Kontaktierung der Kontaktleiter mit den Modulkontakten (38) und den Antennenkontakten (39) und Ausbildung der Drahtverbindungen (60) durch Abtrennung der Kontaktleiterenden die Ausbildung einer Knickstelle (61, 62) durch Ausknicken der Drahtverbindungen bei Ausführung der überlagerten Schwenk-/Translationsbewegung (63, 64) erfolgt.

8. Verfahren nach einem der Ansprüche 1 bis 7,
**dadurch gekennzeichnet,**
**dass** vor Positionierung der Kontaktleiter (23, 24) relativ zu den Modulkontakten (21, 22, 38) und Positionierung der Kontaktleiter relativ zu den Antennenkontakten (16, 16, 39) auf die Modulkontakte und/oder die Antennenkontakte blattförmig ausgebildete Lötdepots aufgebracht werden.

9. Verfahren nach Anspruch 8,
**dadurch gekennzeichnet,**
**dass** vor Applikation der Lötdepots auf die Modulkontakte (21, 22, 38) und/oder die Antennenkontakte (16, 16, 39) Flussmitteldepots auf die Modulkontakte und/oder Antennenkontakte appliziert werden.

## Claims

1. A method for producing a chip card (57, 58), the chip card (57, 58) comprising a card body (10, 36) which is equipped with a cavity (19, 35) in the top side (12) thereof, having an antenna (14, 47) arranged in the card body and a chip module (11, 37) arranged in the cavity, comprising the following method steps:
- positioning the chip module (11, 37) with module contacts (21, 22, 38) aligned upwardly;
- positioning the card body with antenna contacts (16, 17, 39) aligned upwardly;
**characterised by**
- positioning contact conductors (23, 24) with a flat ribbon cross-section (25) relative to the module contacts, in such a manner that the contact conductors are aligned parallel to one another at the distance of the module contacts, extend in an overlapping position with the module contacts and extend beyond a lateral edge of the chip module together with contact conductor ends;
- positioning the contact conductor ends so as to overlap the antenna contacts of the card body, wherein the chip module is arranged parallel to the top side of the card body, with the lateral edge (30) of the chip module being arranged parallel and adjacent to an opening edge (29) of the cavity;
- contacting the contact conductors with the module contacts;
- contacting the contact conductors with the antenna contacts;
- separating the contact conductor ends for forming wire connections (27, 28, 40, 60) between the module contacts and the antenna contacts;
- pivoting the chip module around its lateral edge and inserting the chip module into the cavity of the card body, in such a manner that the module contacts face the antenna contacts.

2. The method according to claim 1,
**characterised in that**
a translational movement of the chip module superposes the pivoting of the chip module (11, 37).

3. The method according to claim 2,
**characterised in that**
before positioning the contact conductors (23, 24) above the antenna contacts (16, 17, 39) and above the module contacts (21, 22, 38), the chip module (11, 37) is positioned relative to the card body (10, 36), in such a manner that the card body and the chip module are arranged in two parallel planes arranged to be offset from each other, and in such a manner that the chip module is arranged above the card body.

4. The method according to claim 3,
**characterised in that**
the chip module (11) is arranged in a chip module accommodation (13) which is arranged above the card body (10).

5. The method according to claim 3 or 4,
**characterised in that**
for positioning the contact conductors (23, 24) above the antenna contacts (16, 17) and for positioning the contact conductors above the module contacts (21, 22), the contact conductors are fed thereto along a feed axis in each case, said feed axis being in each case defined by the respective antenna contact and the respective module contact which are connected to each other by means of the contact conductor.

6. The method according to one of the claims 1 to 5,
**characterised in that**
before positioning the contact conductors (23, 24) relative to the module contacts (21, 22) and before positioning the contact conductors relative to the antenna contacts (16, 17), the contact conductors are equipped with at least one predetermined kink, at least in the area of a contact conductor end which serves for forming the wire connection.

7. The method according to one of the claims 1 to 5,
**characterised in that**
after contacting the contact conductors with the module contacts (38) and with the antenna contacts (39) and after forming the wire connections (60) by separating the contact conductor ends, a kink (61, 62) is formed by bending the wire connections when the superposed pivoting/translational movement (63, 64) is carried out.

8. The method according to one of the claims 1 to 7,
**characterised in that**
before positioning the contact conductors (23, 24) relative to the module contacts (21, 22, 38) and before positioning the contact conductors relative to the antenna contacts (16, 16, 39), solder deposits formed in the shape of a leaf are applied onto the module contacts and/or onto the antenna contacts.

9. The method according to claim 8,
**characterised in that**
before applying the solder deposits onto the module contacts (21, 22, 38) and/or onto the antenna contacts (16, 16, 39), flux deposits are applied onto the module contacts and/or antenna contacts.

## Revendications

1. Procédé pour la fabrication d'une carte à puce (57, 58),
ladite carte à puce (57, 58) comprenant un corps de carte (10, 36) pourvu, dans sa surface supérieure (12), d'une cavité (19, 35), ayant une antenne (14, 47) disposée dans le corps de carte, et un module de puce (11, 37) disposé dans la cavité,
comprenant les étapes de procédé suivantes :
- le positionnement du module de puce (11, 37) avec les contacts de module (21, 22, 38) orientés vers le haut ;
- le positionnement du corps de carte avec les contacts d'antenne (16, 17, 39) orientés vers le haut ;
**caractérisé par**
- le positionnement de conducteurs de contact (23, 24) ayant une section transversale en forme de câble plat (25) par rapport aux contacts de module, de telle manière que les conducteurs de contact sont alignés en parallèle les uns par rapport aux autres à une distance correspondant à celle-ci des contacts de module, s'étendent de façon à se chevaucher avec les contacts de module et s'étendent au-delà d'un bord latéral du module de puce conjointement avec des extrémités des conducteurs de contact ;
- le positionnement des extrémités des conducteurs de contact de façon à se chevaucher avec les contacts d'antenne du corps de carte, ledit module de puce étant disposé en parallèle par rapport à la surface supérieure du corps de carte et étant disposé, avec le bord latéral (30) du module de puce, en parallèle et adjacent à une bordure d'ouverture (29) de la cavité ;
- la mise en contact des conducteurs de contact avec les contacts de module ;
- la mise en contact des conducteurs de contact avec les contacts d'antenne ;
- la séparation des extrémités des conducteurs de contact pour former des liaisons à fil (27, 28, 40, 60) entre les contacts de module et les contacts d'antenne ;
- le pivotement du module de puce autour de son bord latéral et l'insertion du module de puce dans la cavité du corps de carte, de telle manière que les contacts de module font face aux contacts d'antenne.

2. Procédé selon la revendication 1,
**caractérisé en ce qu'**
un mouvement de translation du module de puce (11, 37) superpose le pivotement du module de puce (11, 37).

3. Procédé selon la revendication 2,
**caractérisé en ce qu'**
avant le positionnement des conducteurs de contact (23, 24) au-dessus des contacts d'antenne (16, 17, 39) et au-dessus des contacts de module (21, 22, 38), un positionnement relatif du module de puce (11, 37) par rapport au corps de carte (10, 36) est effectué de telle manière que le corps de carte et le module de puce sont disposés dans deux plans parallèles disposés de façon décalée l'un par rapport à l'autre, et de telle manière que le module de puce est disposé au-dessus du corps de carte.

4. Procédé selon la revendication 3,
**caractérisé en ce que**
le module de puce (11) est disposé dans un logement de module de puce (13) qui est disposé au-dessus du corps de carte (10).

5. Procédé selon la revendication 3 ou 4,
**caractérisé en ce que**
pour le positionnement des conducteurs de contact (23, 24) au-dessus des contacts d'antenne (16, 17) et pour le positionnement des conducteurs de contact au-dessus des contacts de module (21, 22), les conducteurs de contact chacun sont introduits le long d'un axe d'introduction, lesdits axes d'introduction étant définis par le contact d'antenne respectif et le contact de module respectif qui sont reliés entre eux au moyen du conducteur de contact.

6. Procédé selon l'une quelconque des revendications 1 à 5,
**caractérisé en ce qu'**
avant un positionnement des conducteurs de contact (23, 24) par rapport aux contacts de module (21, 22) et avant un positionnement des conducteurs de contact par rapport aux contacts d'antenne (16, 17), les conducteurs de contact sont munis d'au moins un pli rainé prédéterminé, au moins dans la région d'une extrémité de conducteur de contact qui sert à former la liaison à fil.

7. Procédé selon l'une quelconque des revendications 1 à 5,
**caractérisé en ce qu'**
après la mise en contact des conducteurs de contact avec les contacts de module (38) et avec les contacts d'antenne (39) et après la formation des liaisons à fil (60) au moyen de la séparation des extrémités des conducteurs de contact, un pli rainé (61, 62) est formé en pliant les liaisons à fil lors de l'exécution du mouvement de pivotement/de translation (63, 64) superposé.

8. Procédé selon l'une quelconque des revendications 1 à 7,
**caractérisé en ce qu'**
avant le positionnement des conducteurs de contact (23, 24) par rapport aux contacts de module (21, 22, 38) et avant le positionnement des conducteurs de contact par rapport aux contacts d'antenne (16, 16, 39), des dépôts de brasure réalisés en forme de feuille sont étalés sur les contacts de module et/ou sur les contacts d'antenne.

9. Procédé selon la revendication 8,
**caractérisé en ce qu'**
avant l'application des dépôts de brasure sur les contacts de module (21, 22, 38) et/ou sur les contacts d'antenne (16, 16, 39), des dépôts de flux sont appliqués sur les contacts de module et/ou sur les contacts d'antenne.
